(19) Europäisches Patentamt
European Patent Office
Office européen des brevets

(11) **EP 0 658 934 B1**

(12) **EUROPÄISCHE PATENTSCHRIFT**

(45) Veröffentlichungstag und Bekanntmachung des Hinweises auf die Patenterteilung:
**29.09.1999 Patentblatt 1999/39**

(51) Int Cl.$^6$: **H01L 23/367**

(21) Anmeldenummer: **94119057.1**

(22) Anmeldetag: **02.12.1994**

(54) **Kühlkörper**

Heat sink

Dissipateur de chaleur

(84) Benannte Vertragsstaaten:
**AT CH DE FR GB IT LI**

(30) Priorität: **15.12.1993 DE 9319259 U**

(43) Veröffentlichungstag der Anmeldung:
**21.06.1995 Patentblatt 1995/25**

(73) Patentinhaber: **SIEMENS AKTIENGESELLSCHAFT
80333 München (DE)**

(72) Erfinder: **Hoffmann, Ingolf, Dipl.-Phys.
D-91074 Herzogenaurach (DE)**

(56) Entgegenhaltungen:
**DE-U- 9 315 558**          **US-A- 4 899 210**

• **IEEE Southeastcon 86, Richmond, Virginia, March 23-25, 1986, SS. 192-194, A.D. SNIDER: "A New Strategy for Heat Sink Design"**

**Beschreibung**

Die Erfindung bezieht sich auf einen Hochleistungs-Kühlkörper für einen Halbleiterbauelement, der einen Rippengrund und mehrere auf einer Oberfläche dieses Rippengrundes beabstandete Rippen aufweist.

Solche Kühlkörper sind im Handel erhältlich (Prospekt "Bauelemente" der Firma Seifert Electronic 1993).

Durch die Kühlrippen, die auf einer wärmeabgebenden festen Oberfläche angebracht sind, wird der Wärmeübergang von festen Körpern an das umgebende flüssige oder gasförmige Medium verbessert. Anstelle von Rippen werden auch Scheiben oder Nadeln verwendet. Die auf diese Weise erreichbare Vergrößerung der Oberfläche bewirkt zwar nicht im gleichen Maße auch eine Verbesserung des Wärmeübergangs, weil die einzelnen Segmente sich bei der Wärmeabgabe gegenseitig mehr oder weniger beeinflussen. Außerdem ist die Temperatur dieser Segmente nicht gleich der Temperatur der Grundfläche, weil ein Temperaturgefälle zum Segmentende hin unvermeidlich ist.

Dennoch wählt man in vielen Fällen diesen verhältnismäßig einfachen Weg zur Kühlung von Bauelementen, Baugruppen und Geräten. Ein besonderer Vorteil ist hier die Möglichkeit, berippte Kühlkörper den oft komplizierten Raumverhältnissen weitgehend angleichen zu können. Die geometrische Gestalt der handelsüblichen Rippenkörper ist entsprechend mannigfaltig-man unterscheidet berippte Platten mit ebener Grundfläche, Rohre mit zylindrischer oder kegeliger Grundfläche. Die Rippen können dabei unterbrochen, wie bei Segmentrippen und Nadelrippen, oder durchgehend sein, wobei die durchgehenden meist als Kreis- oder Rechteckrippe ausgeführt werden. Der freien Gestaltungsmöglichkeit sind kaum Grenzen gesetzt, wie die Vielfalt der gegenwärtig im Handel erhältlichen Kühlkörper für Halbleiterbauelemente zeigt.

Die mit geraden Längsrippen versehene ebene Fläche wird am häufigsten angewendet. Für dessen Rippenkörper lassen sich verhältnismäßig übersichtliche Bemessungsgleichungen angeben, wenn die vereinfachende Annahme einer Konstanz der Wärmeübertragungskoeffizienten $\alpha$ an allen Stellen weiterhin vorausgesetzt wird. Würde man beispielsweise die Änderung des Wärmeübergangskoeffizienten $\alpha$ mit zunehmender Länge der berippten, senkrecht stehenden ebenen Platte berücksichtigen, so müßte im Hinblick auf einen optimalen Wärmeübergang das Rippenprofil mit der Länge geändert werden, was man aus wirtschaftlichen Gründen vermeiden möchte.

Für die konvektive Wärmeübertragung gilt ein ganz einfaches Gesetz, wonach der in die Umgebung übertretende Wärmestrom $\dot{Q}$ (Warme je Zeiteinheit) proportional der Wärmeübergangszahl $\alpha$, der Geräteoberfläche A und einer Temperaturdifferenz $\Delta\theta$ ist. Die Temperaturdifferenz wird in einfachen Fällen aus der Wand- und Umgebungstemperatur gebildet. Die Wärmeübergangszahl $\alpha$ hängt von den Eigenschaften und der Geschwindigkeit der umgebenden fluiden Phase sowie von der geometrischen Gestalt der Geräteoberfläche ab. Die zuletzt genannte Abhängigkeit kann so verwickelt sein, daß man fast immer gezwungen ist, die Wärmeübergangzahl experimentell zu bestimmen. In Zusammenhang mit der Ähnlichkeitstheorie vermag man dann aber noch recht zuverlässige Gleichungen mit großem Gültigkeitsbereich aufzustellen. Im Aufsatz "Die Rippe als Kühlelement" von H. Brauer, abgedruckt in der DE-Zeitschrift "Siemens-zeitschrift", Band 42, 1986, Heft 7, Seiten 521 bis 527, werden die verwickelten Zusammenhänge der zahlreichen Einflußgrößen beim Wärmeübergang und jeweils in Form einer Gleichung dargestellt. Diese Formeln lassen die komplizierten Zusammenhänge der einzelnen Einflußgrößen bei der konvektiven Wärmeübertragung erkennen. Da das Temperaturgefälle (bzw. die Übertemperatur) in den meisten Fällen erst aus dem Wärmeübergangskoeffizienten $\alpha$ errechnet werden soll und dies seinerseits die Größe des Wärmeübergangskoeffizienten $\alpha$ sowie der Stoffwerte beeinflußt, wird die Lösung erst nach mehreren Berechnungsgängen (iteratives Verfahren) gefunden werden können.

Die auf dem Markt erhältlichen Strangpreß-Kühlkörper erlauben nur eine Wärmestromdichte von ungefähr 10 kJ/sm², wobei für Kühlkörper mit eingepreßten Rippen eine Wärmestromdichte von ungefähr 22 kJ/sm² erreicht wird. Noch höhere Wärmestromdichten sind bisher nur mit Siedekühlern, beispielsweise einer heat pipe, oder Flüssigkeitskühlern erreichbar. Diese Kühlsysteme besitzen jedoch neben dem System-auch einen Preisnachteil vom Faktor 3 bis 10.

Bei den heutzutage erhältlichen abschaltbaren Stromrichtermoduln, beispielsweise bipolarer Leistungstransistor (LTR) oder Insulated-Gate-Bipolar-Transistor (IGBT), ist bei guter strommäßiger Ausnutzung eine Verlustleistung von bis zu 1400 W abzuführen. Dabei ergeben sich Wärmestromdichten von bis zu ungefähr 80 kJ/sm². Im Vergleich dazu tritt bei einer Herdplatte eine Wärmestromdichte von ungefähr 30 kJ/sm² auf. Diese Verlustleistung soll aus Kostengründen und wegen eines geringen Aufwandes mittels eines Kühlkörpers durch erzwungene Konvektion abgeführt werden.

Der Erfindung liegt nun die Aufgabe zugrunde, einen Kühlkörper für ein derartiges Halbleiterbauelement anzugeben.

Diese Aufgabe wird erfindungsgemäß mit dem Merkmal des Anspruchs 1 gelöst.

Durch die erfindungsgemäße Ausgestaltung des Hochleistungs-Kühlkörpers wird jeder Kühlrippe des Kühlkörpers die gleiche Verlustleistung zugeführt, wodurch die Gesamtverlustleistung auf mehrere Rippen gleichmäßig aufgeteilt wird. Somit erhält man einen konstanten Rippenwirkungsgrad entlang des gesamten Querschnitts eines erfindungsgemäßen Hochleistungs-Kühlkörpers.

Bei einer vorteilhaften Ausführungsform des vorgenannten erfindungsgemäßen Hochleistungs-Kühlkörpers enden alle Rippen des Kühlkörpers in einer Ebene, die parallel zum Halbleiterbauelement verläuft. Dadurch erhält man ein quadratisches bzw. bei mehreren Halbleiterbauelementen ein quaderförmiges Bauvolumen des Kühlkörpers wie bei den im Handel erhältlichen Kühlkörpern.

Weitere vorteilhafte Ausgestaltungen sind den abhängigen Ansprüchen 2 bis 8 zu entnehmen.

Zur weiteren Erläuterung wird auf die Zeichnung bezug genommen, in der mehrere Ausführungsbeispiele des erfindungsgemäßen Kühlkörpers schematisch veranschaulicht sind.

Figur 1   zeigt einen Ausschnitt aus einem herkömmlichen Kühlkörper, die

Figur 2   zeigt einen vorteilhaften erfindungsgemäßen Kühlkörper, in

Figur 3   ist in einem Diagramm über dem Kühlkörper-Querschnitt der Wirkungsgrad $\eta$ eines konventionellen und des erfindungsgemäßen Kühlkörpers aufgetragen, und die

Figur 4   veranschaulicht einen weiteren vorteilhaften erfindungsgemäßen Kühlkörper.

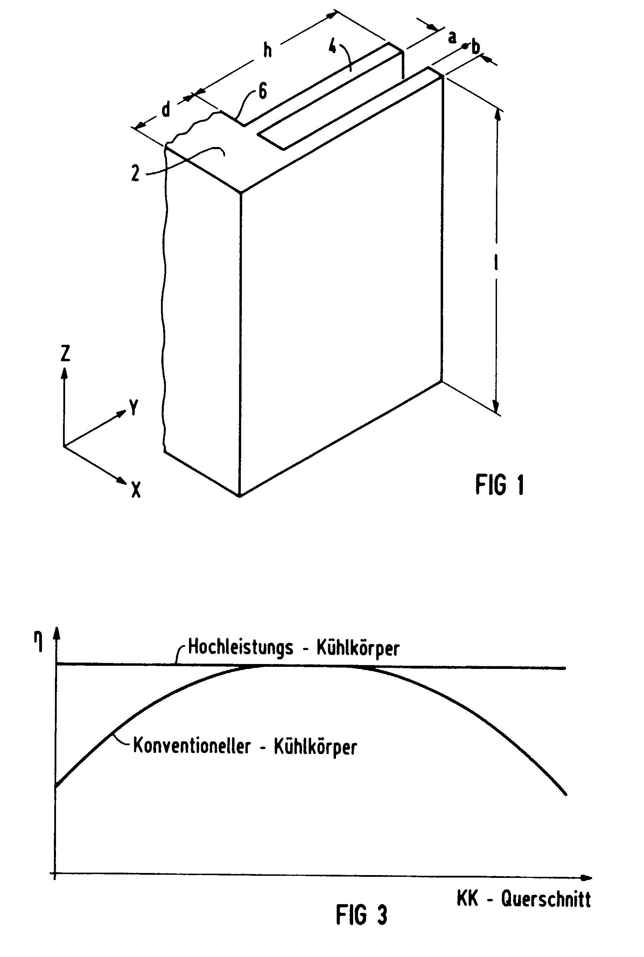

Die Figur 1 zeigt einen Ausschnitt aus einem herkömmlichen Kühlkörper, der aus einem Rippengrund 2 und mehreren beabstandeten Rippen 4 besteht, von denen bei dieser Ausschnittsdarstellung nur zwei Rippen veranschaulicht sind. Die Hohe der Rippe 4 wird mit h und deren Dicke mit b bezeichnet. Ferner wird die Länge der Rippe 4 bzw. des Kühlkörpers mit 1 bezeichnet. Anhand der Darstellung ist z die Längskoordinate und x die Breitenkoordinate des Kühlkörpers. Die Stärke bzw. Höhe des Rippengrundes 2 ist mit d und der Abstand der Rippen 4 zueinander mit a bezeichnet.

Aus dem Inneren des Rippengrundes 2 tritt die Wärme in die Rippe 4 ein und wird von den Rippenflanken durch Konvektion an die Umgebung abgegeben. Ein sehr kleiner Anteil der Wärme wird stets noch unmittelbar von der Rippengrundoberfläche 6 an die Umgebung übertragen. Für die von der Rippe 4 an die Umgebung abgegebene Wärme $\dot{Q}$ läßt sich die Beziehung

$$\dot{Q} = \alpha \, H \, \Delta\theta$$

angeben, wobei H die Rippenoberfläche, $\alpha$ die Wärmeübertragungszahl und $\Delta\theta$ die Temperaturdifferenz zwischen einer über die Rippenhöhe h gemittelten Temperatur und der Temperatur des umgebenden Mediums ist. Aus der eingangs genannten veröffentlichung ist bekannt, daß der Rippenwirkungsgrad stets kleiner als 1 ist und damit von einer Rippe 4 möglichst viel Wärme abgegeben wird, sollte dieser Rippenwirkungsgrad möglichst wenig von diesem Wert 1 abweichen. Der Rippenwirkungsgrad ist abhängig von der sogenannten Rippenkennzahl, eine dimensionslose Zahl, die aus der Wärmeleitzahl $\lambda$ des Rippenwerkstoffes, der Rippenhöhe h, der Rippendicke b und der Wärmeübergangszahl $\alpha$ berechnet wird. Der Rippenwirkungsgrad nimmt ab, wenn die Rippenkennzahl wächst. Damit man große Werte für den Rippenwirkungsgrad erhält, muß die Rippenkennzahl abnehmen, d.h. die Rippenhöhe h muß klein und die Rippendicke b groß sein. Jedoch wird mit kleiner werdender Rippenhöhe h auch die Rippenoberfläche H maßgeblich kleiner. Ferner ergeben sich kleine Werte für die Rippenkennzahl, wenn die Wärmeleitzahl $\lambda$ des Rippenmaterials groß ist.

Da man stets bemüht ist, von der Rippenoberfläche H einen möglichst großen Wärmestrom $\dot{Q}$ an die Umgebung abzuführen, muß gemäß der angegebenen Gleichung auch die mittlere Rippentemperatur vergrößert wird. Somit ändert sich der Wärmestrom $\dot{Q}$ gemäß der angegebenen Gleichung nicht proportional, sondern unterproportional zu der Wärmeübergangszahl $\alpha$. Aus diesen Erläuterungen folgt also, daß die Vergrößerung der Wärmeübergangszahl $\alpha$ keineswegs im gleichen Maße zu einer Vergrößerung der von der Rippe 4 abgegebenen Wärme Q führt, da eine Erhöhung von der Wärmeübergangszahl $\alpha$ eine Reduzierung der Temperaturdifferenz $\Delta\vartheta$ bewirkt.

Bei einem Kühlkörper sind immer mehrere Rippen 4 nebeneinander beabstandet angeordnet. Der Rippenabstand a ist immer sehr klein, wodurch die Wärmeabgabe stark beeinflußt wird. An den Flanken parallel angeströmter Rippen 4 bildet sich sowohl für die Geschwindigkeit als auch für die Temperatur eine Grenzschicht aus. Diese Grenzschicht ist bei kleinem Rippenabstand a größer als bei großem. Besonders dicke Grenzschichten ergeben sich am Rippenfuß. Da in erster Näherung die Wärmeübergangszahl $\alpha$ umgekehrt proportional der Grenzschichtdicke ist, hat die Wärmeübergangszahl $\alpha$ am Rippenfuß den kleinsten Wert und in Richtung zur Rippenspitze ist diese Zahl ansteigend. Um den Wirkungsgrad zu verbessern, ist man bestrebt, eine über die Rippenhöhe konstante Wärmeübergangszahl $\alpha$ zu erhalten. Zu diesem Zweck wird die Strömung so geleitet, daß sie die Umgebung des Rippenfußes besonders stark betrifft.

Die Berechnung des Rippenwirkungsgrades setzt stets die Kenntnis der Wärmeübergangszahl $\alpha$ voraus. Dabei ist zu beachten, daß sich die Wärmeübergangszahlen $\alpha$ streng nur durch das Experiment bestimmen lassen. Theoretische Berechnungen sind wegen der sehr verwickelten Strömungsverhältnisse noch nicht möglich. Der einfachste Fall liegt dann vor, wenn die Rippen längs angeströmt werden und die Rippen seitliche Begrenzungswände für Strömungskanäle bilden. In diesem Fall wird nach der Gleichung

$$\alpha = \frac{\lambda}{l} Nu$$

berechnet. Dabei ist Nu die sogenannte Nusselt-Zahl, die wiederum von der Grashof-Zahl Gr, der Prandtl-Zahl Pr und der Reynolds-Zahl Re abhängig ist. Die Grashof-Zahl Gr ist nur für die Berechnung von Wärmeübergangsvorgängen bei freier Konvektion von Bedeutung. Die Gleichung für die Wärmeübergangszahl $\alpha$ hat einen sehr großen Anwendungsbereich. Sie gilt für praktisch alle Reynolds-Zahlen Re oberhalb von 2320 und für Prandtl-Zahlen Pr oberhalb von etwa 0,5.

Mit diesen Formeln läßt sich durch einen iterativen Optimierungsprozeß die zu erwartende Rippenleistung bestimmen. Die Anzahl n der Rippen 4 des Kühlkörpers ergeben sich dann aus der abzuführenden Gesamtleistung $P_G$ und der Rippenleistung $Q_R$. Dies gilt jedoch nur dann, wenn jeder Kühlkörperrippe 4 die gleiche Verlustleistung $P_R$ zugeführt wird.

Diese Voraussetzung kann nur dann erfüllt werden, wenn gemäß der erfinderischen Erkenntnis alle Rippenfüße der Rippen 4 des Kühlkörpers auf einer Fläche konstanter Temperatur stehen. D.h., eine den Rippen 4 zugewandte Seite 6 des Rippengrundes 2, auch Rippengrundoberfläche genannt, ist konvex zu einer einem Halbleiterbauelement 8 zugewandten Seite 10 des Rippengrundes 2, auch Rippengrundunterfläche genannt, ausgebildet. Durch diese Ausgestaltung des erfindungsgemäßen Hochleistungs-Kühlkörpers kann man die abzuführende Gesamtleistung $P_G$ durch die Rippenleistung $P_R$ teilen, um die Anzahl n der Rippen 4 dieses Kühlkörpers zu erhalten. Dabei wird jeder Rippe 4 die gleiche Verlustleistung $P_R$ zugeführt.

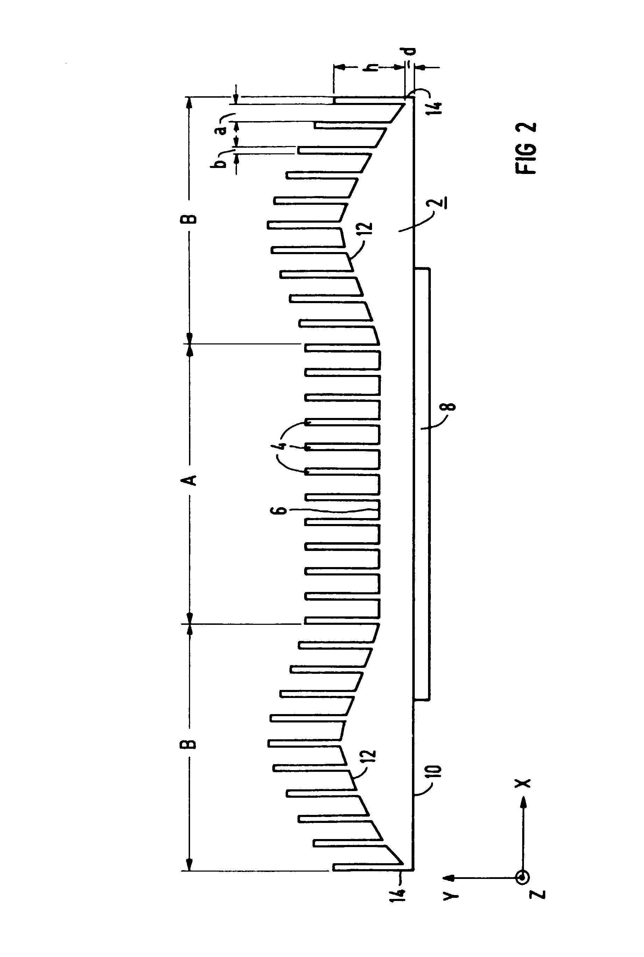

Die Figur 2 zeigt einen erfindungsgemäßen Kühlkörper im Querschnitt für ein Halbleiterbauelement 8, wobei die Grundfläche des Kühlkörpers größer ist als die Grundfläche des Halbleiterbauelements 10. Bei dieser Anordnung wird ein minimaler Temperaturgradient im Rippengrund 2 zugelassen, damit man realistische Werte für die Stärke d des Rippengrundes 2 erhält. Der Randbereich, gekennzeichnet durch B, der Rippengrundoberfläche 6 ist mit einer wulstartigen Wölbung 12 versehen, die zum Rand 14 des Kühlkörpers hin abfällt. Die wulstartige Wölbung 12 ist derartig ausgebildet, daß zwischen benachbarten Rippen 4 eine geringe Temperaturdifferenz $\Delta\theta_R$, beispielsweise $\Delta\theta_R = 0,3$ K auftritt. Im Zentrum A des Kühlkörpers sind die Rippenfüße der Rippen 4 auf einer Fläche konstanter Temperatur angeordnet, d.h. zwischen benachbarten Rippen 4 tritt keine Temperaturdifferenz $\Delta\theta_R$ auf. Durch diese Ausgestaltung erhält man einen Hochleistung-Kühlkörper, wobei jeder Kühlrippe 4 die gleiche Verlustleistung $P_R$ zugeführt wird und die abzuführende Gesamtleistung $P_G$ sich aus der Anzahl n der Kühlrippen 4 ergibt.

Wenn dieser Kühlkörper für ein Halbleiterbauelement 8 vorgesehen ist, ist die Grundfläche des Kühlkörpers quadratisch und die wulstartige Wölbung 12 bildet einen geschlossenen Ring, d.h. das in der Figur 2 dargestellte Profil erstreckt sich auch in z-Richtung des Kühlkörpers. Wenn mehrere Halbleiterbauelemente 8 mittels eines Kühlkörpers gekühlt werden sollen, so können entsprechend der Anzahl der Halbleiterbauelemente 8 Kühlkörper für Einzelelemente vorgesehen sein, die stoffschlüssig miteinander verbunden sind. Derartige Kühlkörper für ein oder mehrere Bauelemente 8 lassen sich mittels Gießtechniken erstellen. Soll dagegen der Kühlkörper aus Strangpreßprofilen erstellt werden, so wird auf die dargestellte Profilierung in z-Richtung des Kühlkörpers verzichtet, d.h. das dargestellte Profil gemäß Figur 2 bleibt entlang der z-Richtung des Kühlkörpers konstant.

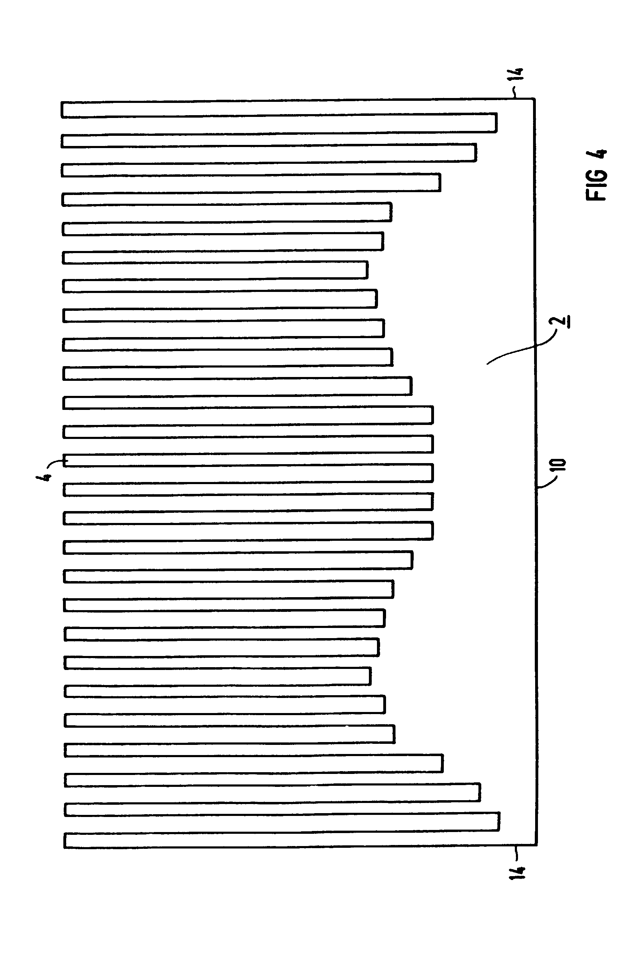

In Figur 3 ist in einem Diagramm der Wirkungsgrad eines konventionellen Kühlkörpers und eines erfindungsgemäßen Hochleistungs-Kühlkörpers über den Kühlkörperquerschnitt dargestellt. Diesem Diagramm kann entnommen werden, daß der Wirkungsgrad unweit vom Zentrum des Kühlkörpers schon merklich abfällt, wogegen der Wirkungsgrad beim erfindungsgemäßen Hochleistung-Kühlkörper über seinen gesamten Querschnitt konstant bleibt. D.h., um mit einem konventionellen Kühlkörper dieselbe Verlustleistung wie mit dem Hochleistungs-Kühlkörper abführen zu können, muß die Grundfläche dieses Kühlkörpers um ein Mehrfaches größer sein als die Grundfläche eines erfindungsgemäßen Hochleistungs-Kühlkörpers.

In der Figur 4 ist eine weitere vorteilhafte Ausführungsform des Hochleistungs-Kühlkörpers dargestellt. Bei dieser Ausführungsform münden die Enden der Rippen 4 alle in einer Ebene, die zu der Rippengrundunterfläche 10 des Rippengrundes 2 räumlich parallel liegt. Dadurch erhält man ein quaderförmiges Bauvolumen, genauso wie die im Handel erhältlichen Kühlkörper. Dieser Kühlkörper ist als Strangpreßprofil für vier Halbleiterbauelemente 8 bemessen, d.h. das dargestellte Profil erstreckt sich konstant in der z-Richtung des Kühlkörpers. Der Kühlkörper hat die Abmessungen 250 mm x 170 mm x 750 mm und weist 25 Rippen 4 auf. Die Halbleiterbauelemente 8, insbesondere IGBT-Module, weisen jeweils eine Grundfläche von 130 mm x 140 mm auf. Mit einem Volumenstrom von 1700 $m^3$/h, erzeugt durch einen Ventilator, läßt sich pro Modul eine Verlustleistung von 1350 W bei einer Erwärmung am Modul von $\Delta T = 50$ K, wobei die Lufterwärmung 13 K beträgt. Somit ergibt sich hier eine Wärmestromdichte, die mit herkömmlichen Kühlrippen nicht bewältigt werden kann.

**Patentansprüche**

1. Hochleistungs-Kühlkörper für einen Halbleiterbauelement, der einen Rippengrund (2) und mehrere auf einer Oberfläche (6) dieses Rippengrundes (2) beabstandete Rippen (4) aufweist, wobei im Randbereich (B) der Rippengrundoberfläche (6) dieses Rippengrundes (2) derart mit einer wulstigen Wölbung versehen ist, daß bei der Verwendung dieses Kühlkörpers mit einem zu kühlenden Halbleiterbauelement, dessen Grundfläche kleiner ist als die Grundfläche des Rippengrundes (2), die Rippengrundoberfläche (6) über ihrer Fläche im wesentlichen keine Temperaturdifferenz aufweist.

2. Hochleistungs-Kühlkörper nach Anspruch 1, **dadurch gekennzeichnet**, daß der Rippengrund (2) eine quadratische Grundfläche aufweist und daß die wulstartige Wölbung (12) einen geschlossenen Ring bildet.

3. Hochleistungs-Kühlkörper nach Anspruch 1, **dadurch gekennzeichnet**, daß der Rippengrund (2) eine rechteckige Grundfläche aufweist.

4. Hochleistungs-Kühlkörper nach Anspruch 1 und 3, **dadurch gekennzeichnet**, daß der Kühlkörper ein Strangpreßprofil ist.

5. Hochleistungs-Kühlkörper nach Anspruch 1 und 2, **dadurch gekennzeichnet**, daß mehrere Kühlkörper in Rippenlängsrichtung miteinander stoffschlüssig verbunden sind.

6. Hochleistungs-Kühlökörper nach einem der Ansprüche 1, 2, 3 oder 5, **dadurch gekennzeichnet**, daß der Kühlkörper ein Gießteil ist.

7. Hochleistungs-Kühlkörper nach einem der vorgenannten Ansprüche 1 bis 6, **dadurch gekennzeichnet**, daß alle Kühlrippen (4) die gleiche Höhe (h) aufweisen.

8. Hochleistungs-Kühlkörper nach einem der Ansprüche 1 bis 7, **dadurch gekennzeichnet**, daß die Enden aller Kühlrippen (4) eine Ebene bilden, die räumlich parallel zu einer der Rippengrundoberfläche (6) des Rippengrundes (2) abgewandten Fläche (10) angeordnet ist.

## Claims

1. High-capacity heat sink for a semiconductor component, which heat sink has a fin base (2) and a plurality of fins (4) spaced apart on an upper surface (6) of this fin base (2), wherein in the edge region (B) of the fin base upper surface (6) this fin base (2) is provided with a ridge-like convexity in such a way that when this heat sink is used with a semiconductor component that is to be cooled, the latter's base surface area is smaller than the base surface area of the fin base (2), the fin base upper surface (6) having substantially no difference in temperature over its surface area.

2. High-capacity heat sink according to claim 1, characterised in that the fin base (2) has a square base area and in that the ridge-like convexity (12) forms a closed ring.

3. High-capacity heat sink according to claim 1, characterised in that the fin base (2) has a rectangular base area.

4. High-capacity heat sink according to claims 1 and 3, characterised in that the heat sink is an extruded profiled section.

5. High-capacity heat sink according to claims 1 and 2, characterised in that a plurality of heat sinks are connected together in a material-closing manner in the longitudinal direction of the fins.

6. High-capacity heat sink according to one of claims 1, 2, 3 or 5, characterised in that the heat sink is a cast portion.

7. High-capacity heat sink according to one of the afore-mentioned claims 1 to 6, characterised in that all the cooling fins (4) are of the same height (h).

8. High-capacity heat sink according to one of claims 1 to 7, characterised in that the ends of all the cooling fins (4) form a plane which is arranged so as to be spatially parallel to a surface area (10) which is remote from the fin base upper surface (6) of the fin base (2).

## Revendications

1. Dissipateur de chaleur de grande puissance pour un composant semi-conducteur, qui comporte un fond (2) à nervures et plusieurs nervures (4) distantes sur une face (6) supérieure de ce fond (2) à nervures, ce fond (2) à nervures étant, dans la région (B) de bord de la face (6) supérieure du fond à nervures, doté d'un bombement du genre renflement de telle sorte que, lorsque ce dissipateur de chaleur est utilisé avec un composant semi-conducteur à refroidir dont la surface de base est inférieure à la surface de base du fond (2) à nervures, la face (6) supérieure du fond à nervures ne présente sensiblement pas de différence de température sur sa superficie.

2. Dissipateur de chaleur de grande puissance suivant la revendication 1, **caractérisé** en ce que le fond (2) à nervures possède une surface de base carrée, et en ce que le bombement (12) du genre renflement forme un anneau fermé.

3. Dissipateur de chaleur de grande puissance suivant la revendication 1, **caractérisé** en ce que le fond (2) à nervures possède une surface de base rectangulaire.

4. Dissipateur de chaleur de grande puissance suivant les revendications 1 et 3, **caractérisé** en ce que le dissipateur de chaleur est un profilé filé.

5. Dissipateur de chaleur de grande puissance suivant les revendications 1 et 2, **caractérisé** en ce que plusieurs dissipateurs de chaleur sont mutuellement reliés par liaison de matière dans la direction longitudinale des nervures.

6. Dissipateur de chaleur de grande puissance suivant l'une des revendications 1, 2, 3 ou 5, **caractérisé** en ce que le dissipateur de chaleur est une pièce moulée.

7. Dissipateur de chaleur de grande puissance suivant l'une des revendications 1 à 6, **caractérisé** en ce que toutes les nervures (4) de refroidissement possèdent la même hauteur (h).

8. Dissipateur de chaleur de grande puissance suivant l'une des revendications 1 à 7, **caractérisé** en ce que les extrémités de toutes les nervures (4) de refroidissement forment un plan qui est disposé parallèlement, dans l'espace, à une face (10) opposée à la face (6) supérieure du fond (2) à nervures.

FIG 1

Hochleistungs - Kühlkörper

Konventioneller - Kühlkörper

η

KK - Querschnitt

FIG 3

FIG 2

EP 0 658 934 B1

FIG 4